# EUROPEAN PATENT APPLICATION

(11) **EP 0 677 866 A1**
(43) Date of publication of application: **18.10.1995**
(21) Application number: 95301064.2
(22) Date of filing: 20.02.1995
(51) Int. Cl.: H01J 37/32

(54) **Apparatus for forming film**

(30) Priority: 11.04.1994 JP 72017/94
(71) Applicant: CANON SALES CO., INC., Minato-ku, Tokyo (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semiconductor Proc. Lab. Co. Ltd, Minato-ku, Tokyo (JP); Ohira, Kouichi, c/o Semicond. Proc. Lab. Co. Ltd., Minato-ku, Tokyo (JP); Nishimoto, Yuhko, c/o Semic. Proc. Lab. Co. Ltd., Minato-ku, Tokyo (JP)
(74) Representative: Maury, Richard Philip

(57) **Abstract**

This invention relates to film forming apparatus for forming an insulating film, for example, by the CVD method using a reaction gas in the activated form. It is aimed at simplifying the apparatus in construction, ensuring impartation of high quality to the produced film, enhancing the efficiency of the formation of plasma, or exalting the uniformity of the produced film as by repressing the dispersion of the film thickness. The film forming apparatus comprises first gas discharge means 8 for discharging first reaction gas into a plasma forming part 1, gas activating means for activating said first reaction gas, second gas discharge means 9 for discharging second reaction gas on a substrate in a film forming part 7, and said gas discharge means 9 being provided with gas discharge pipes 22a and 22b, 22c and 22d, 22e and 22f, or 22g and 22h in walls of which a plurality of gas discharge holes are formed, whereby said second reaction gas is discharged from the gas discharge holes to contact said activated first reaction gas and is activated so that a film is formed on said substrate through reaction of said first and second reaction gas.

## Description

### BACKGROUND OF THE INVENTION

### 1. Field of the Invention

This invention relates to an apparatus for forming a film, and more specifically to a film-forming apparatus which is adapted to produce an insulating film, for example, by the CVD (chemical vapor deposition) method using a reaction gas in the activated form.

### 2. Description of the Prior Art:

In the manufacture of semiconductor devices, the CVD devices are useful for the formation of SiO₂ film, PSG film, BSG film, BPSG film, Si₃N₄ film, amorphous Si film, polycrystalline Si film, W film, Mo film, WSi₂ film, MoSi₂ film, and Al film.

The conventional CVD devices are classified by the means of activating a reaction gas into the following three main types:
(1) Thermal CVD devices
(2) Photo-assisted CVD devices
(3) Plasma enhanced CVD devices

The thermal CVD devices are provided with heating means for heating a reaction gas thereby imparting thermal energy to the reaction gas and activating it and are classified by the pressure to be used under the low pressure and the atmospheric pressure type. By the temperature of a substrate, they are classified under the low and the high temperature type. Further, by the means of heating, they are classified under the resistance heating, the induction heating, and the lamp heating type. Then, by the place for installation of the heating means, they are classified under the hot wall and the cold wall type.

The photo-assisted CVD devices are furnished with light emitting means for irradiating a reaction gas with ultraviolet light thereby imparting light energy to the reaction gas and activating it and are capable of forming a film under a low or a high pressure and at a low temperature.

The plasma enhanced CVD devices are endowed with plasma-forming means for directly or indirectly activating a reaction gas by means of an AC electric power or a magnetic field and are generally operated under a low pressure and at a low temperature. By the means to form plasma, they are classified under the parallel plate type for directly activating a reaction gas by the irradiation of a high frequency electric power and the ECR type for indirectly activating a reaction gas by means of electrons to which energy has been preparatorily imparted by a high frequency electric power and a magnetic field.

The method for forming a film by the thermal CVD device at times proves undesirable in respect that the substrate rises to a high temperature. Further, it has room for improvement in such qualities of film as density.

The method for forming a film by the photo-assisted CVD device produces the film also in extraneous portions redundantly and gives rise to a cause for the occurrence of particles. Further, it has such a low deposition rate as to necessitate improvement for the sake of actual use.

The method for forming a film by the plasma enhanced CVD device particularly of the parallel plate type entails irradiation of a substrate with the plasma which possibly inflicts damage on the substrate. In cases where the damage on the substrate poses a problem particularly, the plasma enhanced CVD method of the ECR type is adopted instead. This method is indeed effective in precluding the damage on the substrate and allowing the formation of a film of high density. Since it uses such an extremely high frequency as 2.45 GHz, the device used by this method is inevitably voluminous.

Particularly, in the plasma enhanced CVD device, the shape of the inlet pipe such as for the film-forming gas and the disposition of the gas discharge orifice inside the chamber constitute important factors for the purpose of heightening the efficiency of plasma formation or repressing the dispersion of the film thickness and enhancing the uniformity of the film.

### SUMMARY OF THE INVENTION

The object of this invention is to provide a film-forming apparatus which is simple in construction and is capable of forming an insulating film of high quality and improving the efficiency of plasma formation or repressing the dispersion of the thickness of the formed film and enhancing the uniformity of the film.

In the film-forming apparatus according to this invention, the electromagnetic field for the conversion of a gas into a plasma is effectively applied to a first reaction gas because a first gas inlet device communicates with the housing of a plasma forming chamber in the central part on the upstream side of the plasma forming chamber or is disposed in the central part of the plasma forming chamber. This apparatus, therefore, enjoys high efficiency of plasma formation.

This apparatus is further capable of accelerating the conversion of the reaction gas into the plasma because the distance of travel of the reaction gas is increased by causing the first reaction gas which has been discharged to be received on a relay plate and then moved on the relay plate. As a result, the efficiency of plasma formation is improved.

The reaction gas is uniformly supplied onto the substrate because the gas discharge part of the gas inlet device is disposed above the substrate. The uniformity of the film thickness, therefore, is improved.

Since the gas discharge part is formed in an annular shape, it allows easy passage therethrough of the plasma which flows in from the upstream side of the film forming part as constricted into the central region of the film forming part as by means of a magnetic field, for example.

As the CVD device furnished with the first gas inlet device and the gas inlet device, a CVD device which is provided with an external antenna for radiating an electric power of a frequency of 13.56 MHz into a plasma forming part and a source solenoid for forming a magnetic field inside the plasma forming part is used. As a result, a plasma of a helicon mode having a high density can be generated inside the plasma forming part and a film of high density can be formed.

Since the high-frequency electric power to be applied to the external antenna has such a low frequency as 13.56 MHz, this CVD device obviates the necessity for such means as a waveguide tube capable of generating such an extremely high frequency as 2.45 GHz which would be otherwise required in the case of the CVD device of the ECR type and consequently enjoys simplicity of construction.

Further, the gas inlet device is provided above the substrate as separated from the first gas inlet device. The reaction gases being supplied onto the substrate, therefore, are prevented from reacting with each other en route to the substrate and the occurrence of particles can be prevented.

### BRIEF DESCRIPTION OF THE DRAWINGS

Fig. 1 is a side view illustrating a CVD film-forming apparatus using the helicon mode plasma according to the first embodiment of this invention.

Fig. 2 is a perspective view illustrating in detail an external antenna to be incorporated in the CVD film-forming apparatus using the helicon mode plasma according to the embodiment of this invention.

Fig. 3 is a graph showing the relation of the vertical magnetic field to the solenoid current in the CVD film-forming device using the helicon mode plasma according to the embodiment of this invention.

Fig. 4 is a side view illustrating a first reaction gas inlet pipe to be incorporated in the CVD film-forming apparatus using a helicon mode plasma according to the second embodiment of this invention.

Fig. 5A and 5B are a side view and a plan view illustrating a first reaction gas inlet pipe to be incorporated in the CVD film-forming apparatus using a helicon mode plasma according to the third embodiment of this invention.

Fig. 6A and 6B are a side view and a plan view illustrating a second reaction gas inlet pipe to be incorporated in the CVD film-forming apparatus using the helicon mode plasma according to the first embodiment of this invention.

Fig. 7A and 7B are a side view and a plan view illustrating
a second reaction gas inlet pipe to be incorporated in the CVD film-forming apparatus using a helicon mode plasma according to the fourth embodiment of this invention.

Fig. 8A and 8B are a side view and a plan view illustrating
a second reaction gas inlet pipe to be incorporated in the CVD film-forming apparatus using a helicon mode plasma according to the fifth embodiment of this invention.

Fig. 9A and 9B are a side view and a plan view illustrating
a second reaction gas inlet pipe to be incorporated in the CVD film-forming apparatus using a helicon mode plasma according to the sixth embodiment of this invention.

### DESCRIPTION OF THE PREFERRED EMBODIMENT

Now, preferred embodiments of this invention will be described below with reference to the drawings annexed hereto.

### (1) Description of CVD film-forming apparatuses using a helicon mode plasma according to the first embodiment of this invention:

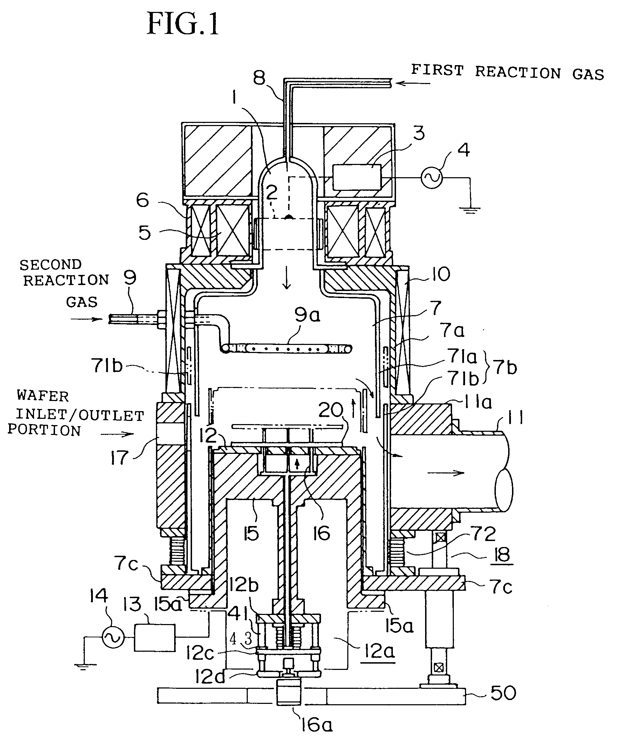

Fig. 1 is a side view illustrating the overall construction of a CVD apparatus according to the first embodiment of this invention. The present embodiment pertains to a CVD apparatus using a helicon mode plasma.

In Fig. 1, the reference numeral 1 stands for a plasma forming chamber (plasma forming part) isolated from the ambience with a cylindrical housing 1a of quartz 15 cm across and 25 cm long and adapted to activate a first reaction gas such as, for example, oxygen gas (O₂ gas) introduced through a first reaction gas inlet pipe (first gas discharge means) 8.

The shape of the first reaction gas inlet pipe 8 and the disposition of a gas discharge hole of the first reaction gas inlet pipe 8 inside the plasma forming chamber 1 are variously conceivable. In the case of the embodiment, the first reaction gas inlet pipe 8 is formed of a slender quartz pipe 6.35 mm in outside diameter and 4 mm in inside diameter and adapted to communicate with the upstream central part of the housing of the plasma forming chamber 1.

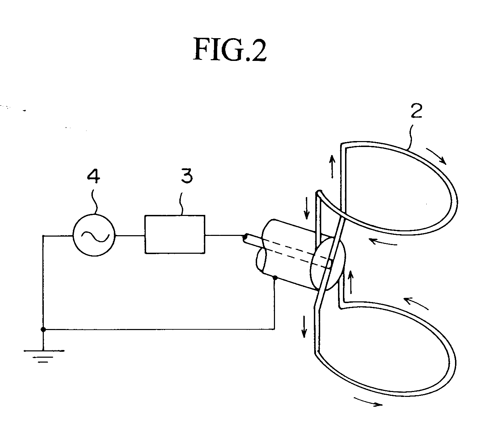

The reference numeral 2 stands for an external antenna attached to the periphery of the plasma forming chamber 1. Two annular conductors separated by a prescribed distance are wound around the upper and the lower peripheral part of the cylindrical plasma forming chamber 1. The distance between the two annular conductors is important for the purpose of adjusting the number of helicon waves or the density of plasma. One example of the shape of the external antenna 2 is illustrated in Fig. 2. In the illustrated external antenna, the RF current is caused to flow in opposite directions through the two annular conductors so as to form a zero mode helicon wave. The helicon wave of a mode of higher order can be formed by varying the shape of the external antenna.

The reference numeral 3 stands for a matching network connected to the external antenna 2 and the reference numeral 4 for an RF power source for feeding an RF electric power of a frequency of 13.56 MHz to the external antenna 2 through the medium of the matching network 3. The RF electric power constitutes an energy source for the formation of plasma.

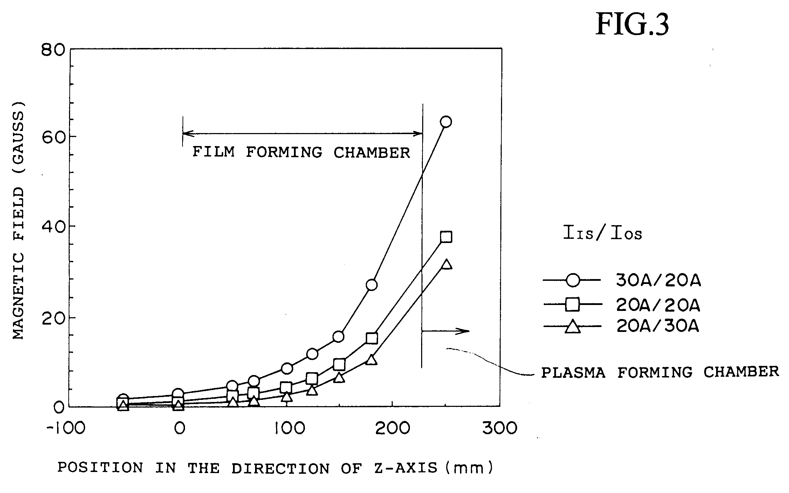

The reference numeral 5 stands for a cylindrical inner solenoid provided around the plasma forming chamber 1 and the reference numeral 6 for a cylindrical outer source solenoid provided around the inner source solenoid 5. The inner source solenoid 5 and the outer source solenoid 6 jointly form a magnetic field in the axial direction inside the plasma forming chamber 1. This magnetic field is capable of forming a helicon wave and necessary for the sake of adjusting the plasma density. The relations of the electric currents passed through the inner solenoid 5 and the outer solenoid 6 respectively to the magnetic field to be generated are shown in Fig. 3. In the diagram, I_{IS} stands for the current through the inner solenoid 5 and I_{OS} for the current through the outer solenoid 6.

The construction of the plasma forming chamber 1 and the peripheral devices thereof which are necessary for the formation of a plasma of high density (not less than 10¹² cm⁻³) of the helicon mode has been described. Particularly, the RF electric power, the magnetic field, and the distance between the two annular conductors of the external antenna 2 constitute important parameters for the formation of plasma.

The reference numeral 7 stands for a film forming chamber (film forming part) isolated from the ambience with a cylindrical housing 7a measuring 30 cm in inside diameter and 22.5 cm in length and connected to the plasma forming chamber 1 on the downstream side thereof.

The film forming chamber 7 is provided with a second reaction gas inlet pipe (second gas discharge means) 9 possessed of a gas discharge part 9a for introducing and discharging a second reaction gas. Thus, the helicon mode plasma formed of the first reaction gas in the plasma forming chamber 1 is supplied to the film forming chamber 7 and, at the same time, the second reaction gas such as, for example, a TEOS gas is introduced through the second reaction gas inlet pipe 9 into the film forming chamber 7. The helicon mode plasma moves toward the downstream side and activates the TEOS gas. As a result, the activated TEOS gas and the oxygen plasma react with each other to induce deposition of a silicon oxide film on a wafer 20.

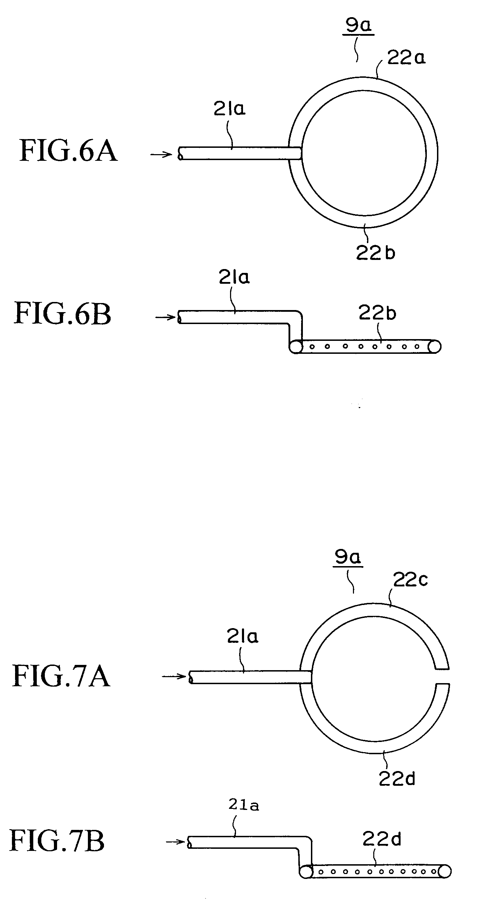

The shape of the gas discharge part 9a of the aforementioned second reaction gas inlet pipe 9 and the disposition of the gas discharge part 9a inside the film forming chamber 7 are variously conceivable. The embodiment which is illustrated in Fig. 6A and Fig. 6B comprises a slender quartz pipe (first gas conduit) 21a for guiding the second reaction gas to the film forming chamber 7 and a gas discharge part 9a communicating on one side with the quartz pipe 21a and branching on the other side into two slender quartz pipes (gas discharge pipes) 22a and 22b each measuring 6.35 mm in outside diameter and 4 mm in inside diameter and jointly rounded in the shape of a ring about 23 cm in diameter. In this case, the two gas discharge pipes 22a and 22b branched from the first gas conduit 21a are rounded in mutually opposite directions by an angle of 180 degrees and are then joined into each other to complete the ring. The inner paths of the gas discharge pipes 22a and 22b communicate with each other. Further, the ring of the gas discharge part 9a is disposed along a plane parallel to the surface of the wafer 20 which is mounted on a wafer retaining device 12. The plasma which flows from the upstream side thereof is constricted into the central region by the magnetic field. The plasma, therefore, is easily passed through the central part of the space enclosed with the ring.

Further, in the quartz pipes 22a and 22b of the gas discharge part 9a, a plurality of gas discharge holes are bored as spaced along the inner circumference of the ring. Through these gas discharge holes, the second reaction gas is discharged onto the wafer 20. Optionally, these gas discharge holes may be formed along the outer circumference of the ring or along the under side of the ring.

It is, however, undesirable to have these gas discharge holes formed on the upper side of the ring. The reason for this undesirability is that when the second reaction gas is blown upward from the gas discharge part, this second reaction gas is activated by the incoming plasma above the gas discharge part, the first reaction gas which has been converted into a plasma reacts with the second reaction gas, and the product of this reaction is suffered to deposit fast on the gas discharge part.

In cases where the reaction product inevitably adheres to the quartz pipes 22a and 22b, these quartz pipes 22a and 22b may be endowed with an increased contact area by the impartation of irregularities to their surfaces so as to prevent the reaction product from peeling off the quartz pipes 22a and 22b and falling onto the wafer 20 on the downstream side.

The number and the size of the gas discharge holes are suitably adjusted, depending on the kind of the second reaction gas to be used. When TEOS is used as the second reaction gas, for example, the holes are formed in a larger diameter than when monosilane is used because the TEOS has higher viscosity than the monosilane.

By separating the oxygen gas inlet pipe 8 and the TEOS gas inlet pipe 9 as described above, the otherwise possible mutual reaction of the two reaction gases in the process of supply is prevented and the possible occurrence of particles is repressed.

The film forming chamber 7 has a double-wall construction which consists of the housing 7a made of quartz or a metal such as aluminum and a protective wall 7b made of quartz or alumina.

The protective wall 7b is disposed along the inner wall of the housing 7a and adapted to be removed separately of the housing 7a. It may be replaced, when necessary, with a freshly supplied protective wall.

The protective wall 7b is separated into an upper protective wall 71a and a lower protective wall 71b which are formed of cylinders such as of quartz in different diameters. For example, the outside diameter of the upper protective wall 71a is smaller than the inside diameter of the lower protective wall 71b. These two protective walls, therefore, form slightly overlapping parts when the wafer retaining device 12 is lowered to the fullest possible extent and they are so set in place as to give rise to these overlapping parts as mentioned above. As a result, when the wafer retaining device 12 is vertically moved in conjunction with an RF electrode 15, the protective walls are vertically moved in the overlapping state as entrained by the motion of the RF electrode 15. The upper protective wall 71b is fastened to the housing 7a. When the housing 7a is vertically moved, therefore, this upper protective wall 71a is vertically moved in concert with the vertical motion of the housing 7a. Further, in the protective wall 7b, openings are formed at the positions corresponding to the positions at which the insertion hole for the second reaction gas inlet pipe 9, a waste gas vent 11, and a wafer inlet/outlet portion 17 are formed in the housing 7a.

The protective wall 7b prevents the product of the mutual reaction of the reaction gases from adhering to the inner wall of the housing 7a. Thus, the reaction product adheres instead to the inner wall of the protective wall 7b.

The purpose of washing the protective wall 7b is attained by exposing the interior of the film forming chamber 7 to the atmospheric pressure, removing the second reaction gas inlet pipe 9, moving the housing 7a upward with a chamber lift 18, taking out the upper protective wall 71a and the lower protective wall 71b, and washing the extracted upper protective wall 71a and lower protective wall 71b until the reaction product adhering to the inner walls of the upper protective wall 71a and the lower protective wall 71b is removed.

By setting a spare protective wall in the place of the extracted protective wall 7b, the formation of a film can be further continued within the CVD device. This measure serves the purpose of improving the throughput of the operation and saving the time and labor and the expense incurred for the maintenance because it obviates the necessity for suspending the operation of the CVD device for a long time for the sake of giving a wash to the interior of the film forming chamber 7.

Optionally, the protective wall 7b, instead of being taken out, may be given an in situ cleaning by introducing an etching gas into the film forming chamber 7 and removing the adhering reaction product by means of etching. As a result, the housing 7a can be prevented from being impaired by etching. Further, by providing the housing 7a around the periphery thereof with heating means and enabling the protective wall 7b to be kept in a heated state in the process of etching, the etching can be accelerated and the effect of the in situ cleaning can be enhanced.

The reference numeral 10 stands for a housing solenoid made of a cylindrical permanent magnet, disposed around the film forming chamber 7, and adapted to apply a suitable magnetic field to the film forming chamber 7. The magnetic field guides the plasma from the plasma forming chamber 1 to the film forming chamber 7 and confines the flow of the plasma within the central region of this flow.

The reference numeral 11 stands for a waste gas vent which is provided in the film forming chamber 7 and to which is connected a gas discharge device for discharging unnecessary reaction gas and lowering the internal pressures of the plasma forming chamber 1 and the film forming chamber 7.

The reference numeral 12 stands for a wafer retaining device (substrate retaining device) provided in the lower part of the film forming chamber 7 and adapted to mount therein the wafer 20. It has an electrostatic chuck for electrostatically fixing the wafer 20 and a heater for heating the wafer 20 both built in a common insulating base. It is vertically moved by a vertically moving mechanism 12a.

Now, the vertically moving mechanism 12a of the wafer retaining device 12 will be described below.

On a ball screw 41 which supports a supporting plate 12b through the medium of an unshown bearing support, a tooth helically threaded round the axis is formed. The ball screw 41 is inserted through an unshown ball nut 43 which is provided on a stationary plate 12c. The ball nut 43 has a tooth helically threaded in the inner wall of the hole thereof and, owing to the engagement of this tooth with the tooth of the ball screw 41, is enabled to support the ball screw 41. By rotating the ball screw 41 with an unshown stepping motor, the wafer retaining device 12 is vertically moved through the medium of the supporting plate 12b and the RF electrode 15.

The reference numeral 13 stands for an RF electrode which is disposed in the lower part of the wafer retaining device 12 as held in contact with the wafer retaining device 12. The RF power source 15 for supplying an electric power of a frequency of 13.56 MHz or 100 kHz is connected to the RF electrode 13 through the medium of a matching network 14. When the electric power of a frequency of 13.56 MHz or 100 kHz is applied to the wafer 20, a negative self-bias DC voltage is applied to the wafer 20 so as to optimize such qualities of the produced film as density and stress.

The reference numeral 16 stands for a wafer lift pin which is moved by vertical moving means 16a through the RF electrode 13 and the through hole of the wafer retaining device 12 and allowed consequently to push the wafer 20 upward and separate the wafer 20 from the mounting surface of the wafer retaining device 12. Then, the wafer 20 so separated is retained on an unshown wafer conveying device and taken out of the wafer inlet/outlet portion 17.

The reference numeral 18 stands for a housing lift for supporting a flange 11a of the waste gas vent 11 and vertically moving the housing 7a of the film forming chamber 7 through the medium of the flange 11a. The housing lift 18 has formed thereon a tooth for causing helical rotation of the ball screw and, owing to the engagement of the helically threaded tooth formed on the inner wall of the hole bored in the ball nut with the tooth of the ball screw, is enabled to support the ball screw. The rotation of the ball screw causes the ball screw to be vertically moved and, through the medium of the flange 11a, further causes the housing 7a to be vertically moved.

The reference numeral 50 stands for a floor on which the housing lift 18 and the CVD device are installed.

As described above, the CVD film forming apparatus according to the present embodiment of this invention is provided with the external antenna 2 for radiating an electric power of a frequency of 13.56 MHz inside the plasma forming chamber 1 and an inner and an outer source solenoid 5 and 6 for forming a magnetic field inside the plasma forming chamber 1. As a result, the helicon mode plasma of high density can be formed in the plasma forming chamber 1 and the film of high density is consequently formed.

Further, since the high-frequency electric power to be applied to the external antenna 2 has such a low frequency as 13.56 MHz, the present apparatus obviates the necessity for such means as a waveguide tube capable of generating such an extremely high frequency as 2.45 GHz which would be otherwise required in the case of the CVD device of the ECR type and consequently enjoys simplicity of construction.

The second reaction gas inlet pipe 9 is provided above the wafer 20 as separated from the first reaction gas inlet pipe 8. The reaction gases in the process of supply onto the wafer 20, therefore, can be prevented from mutual reaction and the possible occurrence of particles can be consequently repressed.

Further, the reaction gases are uniformly supplied onto the wafer 20 because the gas discharge part 9a of the second reaction gas inlet pipe 9 is disposed above the wafer 20. As a result, the uniformity of the film thickness is improved.

The plasma is formed with high efficiency because the first reaction gas inlet pipe 8 communicates with the central part on the upstream side of the plasma forming chamber 1.

### (2) Description of the gas inlet devices for use in the film forming apparatuses according to the second through the sixth embodiment of this invention:

### (A) First reaction gas inlet pipe for introducing and discharging the gas converted into plasma

### (a) Second embodiment

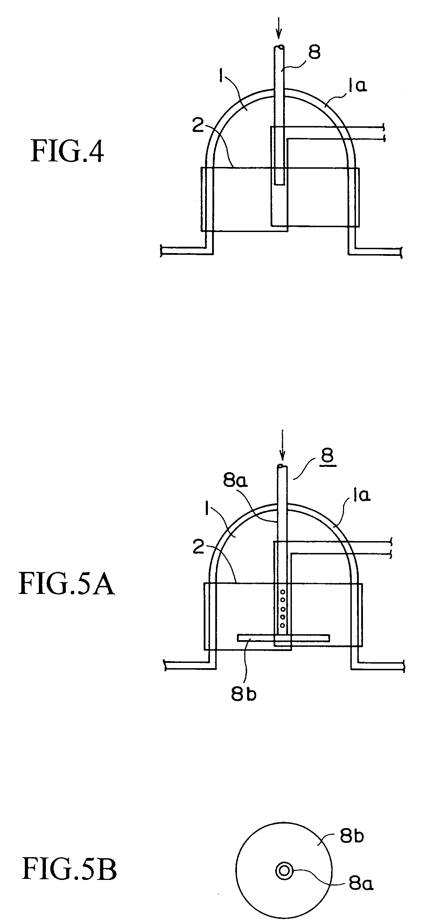

Fig. 4 is a side view illustrating a first reaction gas inlet pipe according to the second embodiment of this invention.

As illustrated in Fig. 4, the first reaction gas inlet pipe (first gas discharge means) 8 for introducing the first reaction gas and discharging it into the plasma forming chamber 1 is formed of a slender quartz pipe having an end part thereof adapted as a gas discharge opening and measuring 6.35 mm in outside diameter and 4 mm in inside diameter, inserted into the plasma forming chamber 1 through the central part on the upstream side of the housing 1a of the plasma forming chamber 1, and disposed in such a manner that the gas discharge opening is located in the central part of the plasma forming chamber 1.

When the first reaction gas is introduced into the first reaction gas inlet pipe 8, it is directly discharged in the central part of the plasma forming chamber 1. At this time, the external antenna 2 radiates an electric wave and the solenoid coils 5 and 6 apply a magnetic field and, as a result, the first reaction gas is converted into a plasma under the influence of the energy from a resultant electromagnetic field.

Incidentally, the electric field and the magnetic field are distributed symmetrically relative to the axis. By introducing the first reaction gas to the central part of the plasma forming chamber 1, therefore, it is efficiently converted into a plasma and the efficiency of plasma formation is improved.

The first reaction gas which has been converted into the plasma flows toward the downstream side and activates the second reaction gas which has been discharged into the film forming chamber 7.

### (b) Third embodiment

Fig. 5A and Fig. 5B are a plan view and a side view illustrating the first reaction gas inlet pipe according to the third embodiment of this invention.

As illustrated in Fig. 5A and Fig. 5B, the first reaction gas inlet pipe (first gas discharge means) 8 for introducing the first reaction gas and discharging it into the plasma forming chamber 1 comprises a gas conduit (gas discharge pipe) 8a adapted to guide the first reaction gas and provided with a plurality of gas discharge holes bored through the pipe wall and a relay plate 8b having attached to the surface thereof the end part of the gas conduit 8a with the axis of the conduit perpendicularly meeting the plate surface, receiving the first reaction gas discharged through the gas discharge holes on the plate surface, and allowing the first reaction gas falling thereon to flow past the edge part of the plate surface in the direction of the downstream side.

When the first reaction gas is introduced into the gas conduit 8a, it flows through the interior of the gas conduit 8a and reaches the interior of the plasma forming chamber 1. Then, it is discharged through the gas discharge holes formed in the pipe wall into the plasma forming chamber 1.

Part of the discharged first reaction gas yields to the conversion into a plasma and the remainder thereof flows toward the downstream side. The first reaction gas thus moving downward is intercepted by the relay plate 8b and then caused to spread out on the surface of the relay plate 8b toward the peripheral part of the plate surface. At this time, the external antenna 2 radiates an electric wave and the solenoid coils 5 and 6 apply a magnetic field and, as a result, the first reaction gas is converted into a plasma under the influence of the energy from a resultant electromagnetic field. Since the distance of this motion of the reaction gas is long, substantially all the reaction gas particles are converted into the plasma while the reaction gas is in the process of this motion.

Further, the gas which has been converted into the plasma flows past the edge part of the plate surface in the direction of the downstream side and activates the second reaction gas which has been introduced into the film forming chamber 7.

The first reaction gas inlet pipe according to the third embodiment of this invention can accelerate the conversion into the plasma because it elongates the distance of motion of the reaction gas by causing the relay plate 8b to intercept the flow of the first reaction gas discharged from the gas conduit 8a and spread this flow on the surface thereof as described above. The efficiency of plasma formation, therefore, is improved.

### (B) Second reaction gas inlet pipe for introducing the second reaction gas and discharging it into the film forming chamber

The second and the third embodiment cited above represent the cases of using the first reaction gas inlet pipe 8 for introducing the reaction gas and discharging it into the plasma forming chamber 1. The fourth and the fifth embodiment to be cited hereinbelow represent the cases of using the second reaction gas inlet pipe 9 for introducing the second reaction gas and discharging it into the film forming chamber 7.

### (a) Fourth embodiment

Fig. 7A and Fig. 7B are a plan view and a side view illustrating the second reaction gas inlet pipe for use in the film forming apparatus according to the fourth embodiment of this invention.

As illustrated in Fig. 7A and Fig. 7B, the second reaction gas inlet pipe (second gas discharge means) 9 for introducing the reaction gas and discharging it into the film forming chamber 7 comprises a first gas conduit 21a for guiding the reaction gas and two gas discharge pipes 22c and 22d communicating with the first gas conduit 21a and branching from the first gas conduit 21a. The two gas conduits 22c and 22d are rounded in the mutually opposite directions from the branching point until they meet each other and complete a ring. The gas discharge pipes 22c and 22d of the gas discharge part 9a have a plurality of gas discharging holes bored through the pipe wall along the inner circumference of the ring.

The ring which consists of the gas discharge pipes 22c and 22d is disposed above the wafer 20 along a plane which is parallel to the surface of the wafer 20.

Through the gas discharge holes in the second reaction gas inlet pipe, the second reaction gas is discharged onto the wafer 20 which is mounted on the wafer retaining device 12. The second reaction gas thus discharged is converted into the plasma, activated by the first reaction gas flowing toward the downstream side, and caused to react with the first reaction gas. As a result, the insulating film, for example, which is the product of the reaction is formed on the wafer 20.

Owing to the mechanism described above, the second reaction gas inlet pipe in the film forming apparatus of the fourth embodiment of this invention produces the same effect as the second reaction gas inlet pipe 9 described in the first embodiment.

### (b) Fifth and sixth embodiments

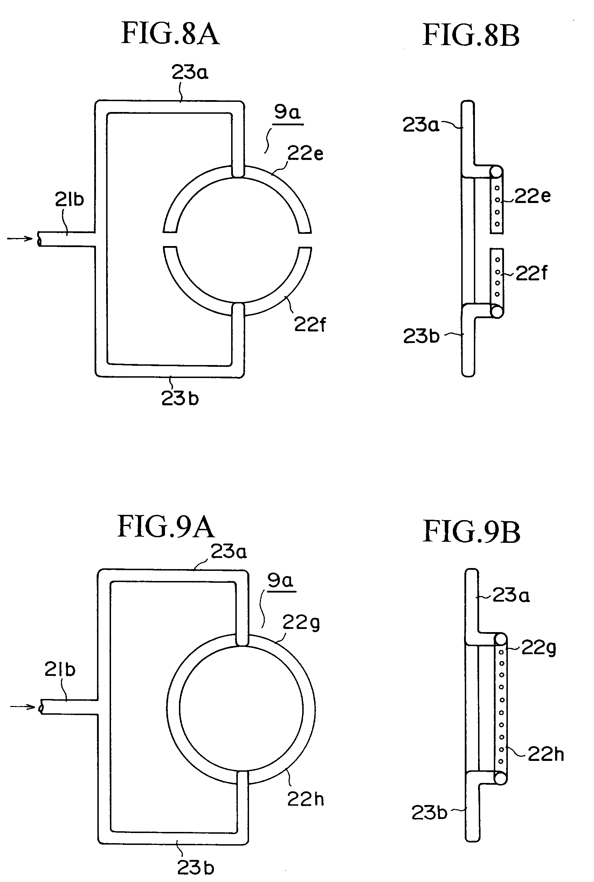

Fig. 8A and Fig. 8B are a plan view and a side view illustrating the second reaction gas inlet pipe for use in the film forming apparatus according to the fifth embodiment of this invention.

As illustrated in Fig. 8A and Fig. 8B, the second reaction gas inlet pipe (second gas discharge means) 9 comprises a first gas conduit 21b for guiding the reaction gas, a second gas conduit consisting of two second gas conduits 23a and 23b communicating with the first gas conduit 21b and branching from the first gas conduit 21b, and a gas discharge pipe consisting of two gas discharge pipes 22e and 22f communicating respectively with the second gas conduits 23a and 23b. The gas discharge pipe is formed in the shape of a ring.

The gas discharge pipes 22e and 22f have a plurality of gas discharge holes bored through the pipe wall along the inner or the outer circumference of the ring, for example.

The ring formed of the gas discharge pipe is disposed above the wafer 20 in a plane which is parallel to the surface of the wafer 20.

Through the gas discharge holes in the second reaction gas inlet pipe 9, the reaction gas is discharged onto the wafer 20 which is mounted on the wafer retaining device 12. The second reaction gas thus discharged is converted into the plasma, activated by the first reaction gas flowing toward the downstream side, and caused to react with the first reaction gas. As a result, the insulating film, for example, which is the product of the reaction is formed on the wafer 20.

Owing to the mechanism described above, the second reaction gas inlet pipe in the film forming apparatus of the fifth embodiment of this invention produces the same effect as the second reaction gas inlet pipe 9 described in the first embodiment.

In the fifth embodiment cited above, the gas discharge pipe forming the gas discharge part 9a is divided into two separate gas discharge pipes 22e and 22f. Optionally, as in the sixth embodiment illustrated in Fig. 9A and Fig. 9B, two separate gas discharge pipes 22g and 22h may be joined in the respective end parts thereof into each other to complete a ring in which the inner paths thereof communicate with each other.

In the fourth through the sixth embodiment cited above, the gas discharge holes are provided along the inner circumference of the ring of the gas conduits of the gas discharge part 9a. Optionally, they may be formed along the outer circumference of the ring or on the lower part of the ring.

### (3) Description of the method for the formation of film by the CVD technique using the helicon mode plasma according to the embodiment of this invention:

Now, the method for forming a silicon oxide film according to the embodiment of this invention by the use of the CVD film forming apparatus illustrated in Fig. 1 will be described below. As the reaction gases, O₂ gas and TEOS (Ar) gas are used. The TEOS (Ar) gas is obtained by using Ar gas as a carrier gas and bubbling this carrier gas through a TEOS solution at normal room temperature. The symbol TEOS is the acronym for tetraethoxy silane [Si(OC₂H₅)₄;(SiO₄C₈H₂₀)].

The conditions for the formation of the film are to be set as follows.
(a) Flow rate ratio of O₂/TEOS (Ar) (standard value = 3),
(b) Total flow rate of reaction gases (O₂ = 1.31 SLM, TEOS (Ar) = 0.44 SLM, standard value = 1.75 SLM),
(c) Gas pressure (standard value = 0.2 Torr),
(d) Substrate temperature (standard value = 350°C),
(e) Wafer position (Positive distance above and negative distance below respectively the lower end of the film forming chamber 7 taken as 0; standard value = +45 mm),
(f) RF power applied to the external antenna 2 (standard value = 1.5 kW),
(g) Electric current through the inner solenoid (standard value = 50 A), and
(h) Electric current through the outer solenoid (standard value = 60 A).

It is allowable to use O₂ gas and SiH₄ gas instead as the reaction gases. In this case, the conditions for the formation of the film are as follows, for example.
(a) Flow rate ratio of O₂/SiH₄ (standard value = 1),
(b) Individual flow rates of reaction gases and total flow rate of gases (standard value of flow rate of 0₂ gas = 30 SCCM, standard value of flow rate of SiH₄ gas = 30 SCCM, and standard value of total flow rate of gases = 60 SCCM),
(c) Gas pressure (standard value = 20 mTorr),
(e) Wafer position (Distance above the lower end of the film forming chamber 7 taken as 0; standard value = 161 mm),
(f) Substrate bias [P_{B}] (standard value of frequency - 100 kHz and standard value of electric power = 200 W),
(g) RF power applied to the external antenna 2 [P_{RF}] (standard value of frequency = 13.56 MHa and standard value of electric power = 1.0 kW),
(h) Electric current through inner solenoid [I_{IS}] (standard value = 50 A), and
(i) Electric current through outer solenoid [I_{OS}] (standard value = 60 A).

First, the wafer 20 is mounted on the wafer retaining device 12 and fixed thereto with the electrostatic chuck. Thereafter, the plasma forming chamber 1 and the film forming chamber 7 are evacuated with a turbo-molecular pump and then retained at a vacuum of not more than 10⁻³ Torr.

Then, the wafer retaining device 12 supporting the wafer 20 thereon is moved upward and set at the prescribed position in the film forming chamber 7. Subsequently, the heater 20 is heated to and retained at the prescribed temperature by means of an unshown heater built in the wafer retaining device 12.

Now, the O₂ gas is introduced at the prescribed flow rate via the first reaction gas inlet pipe 8 into the plasma forming chamber 1 and the TEOS (Ar) gas or the SiH₄ gas is introduced at the prescribed flow rate via the second reaction gas inlet pipe 9 into the film forming chamber 7. Subsequently, the gas pressure inside the film forming chamber 7 is adjusted to and retained at the prescribed magnitude.

Then, electric currents of the prescribed magnitudes are supplied to the inner and the outer solenoid 5 and 6 to induce generation of a magnetic field and, at the same time, an RF electric power of the prescribed magnitude is applied to the external antenna 2 via the matching network 3. As a result, the O₂ gas is activated to generate a helicon mode plasma. This helicon mode plasma flows into the film forming chamber 7 and discharges the role of activating the TEOS gas therein. Then, the activated TEOS gas and the oxygen plasma react with each other to commence the deposition of a silicon oxide film on the wafer 20 at a prescribed deposition rate.

The silicon oxide film is grown on the wafer 20 to the prescribed thickness by allowing the film forming apparatus to remain in the ensuant condition for the prescribed length of time.

The method for film formation according to the embodiment of this invention effects generation of a helicon mode plasma of the first reaction gas by the cooperation of the high-frequency electric power of a frequency of 13.56 MHz and the magnetic field and attains the formation of the film on the substrate by the mutual reaction of this plasma with the second reaction gas activated by the plasma as described above. The produced film enjoys improved density of texture because the helicon mode plasma has a high density.

In the film forming apparatus according to this invention, the plasma is formed with highly satisfactory efficiency because
the first gas inlet device communicates with the housing of the plasma forming chamber in the central part on the upstream side thereof or disposed in the central part of the plasma forming chamber as described above.

Further, the efficiency of the plasma formation is improved by the fact that the retention time of the first reaction gas in the plasma forming part is elongated by causing the relay plate to intercept the incoming first reaction gas and spread it out on the surface thereof.

The uniformity of the thickness of the produced film is improved because the gas discharge part of the gas inlet device is disposed above the substrate and, as a result, the reaction gases are uniformly supplied onto the substrate.

Since the gas discharge part is formed in an annular shape, it permits easy passage therethrough of the plasma which flows in from the upstream side of the film forming part.

As the CVD device furnished with the first gas inlet device and the gas inlet device, the CVD device which is provided with an external antenna for radiating a high-frequency electric power of a frequency of 13.56 MHz into the plasma forming part and a source solenoid for forming a magnetic field inside the plasma forming part is used. As a result, the plasma of helicon mode having a high density can be generated inside the plasma forming part and the film of high density of texture can be formed.

Since the high-frequency electric power to be applied to the external antenna has such a low frequency as 13.56 MHz, this CVD device obviates the necessity for such means as a waveguide tube capable of generating such an extremely high frequency as 2.45 GHz otherwise required in the case of the CVD device of the ECR type and consequently enjoys simplicity of construction.

Further, the gas inlet device is provided above the substrate separately of the first gas inlet device. The reaction gases in the process of supply onto the wafer 20, therefore, can be prevented from mutual reaction and the possible occurrence of particles can be consequently repressed.

Besides, though a combination of oxygen and TEOS, or oxygen and SiH₄ is used as a combination of a first and second reaction gas in the above embodiment, another combination, for example, that of ammonia and SiH₄ or the like can be used.

Further, though from the first gas discharge means 8 is discarged oxygen as a first reaction gas and from the second gas discharge means 9 is discharged TEOS or SiH₄ as a second reaction gas in the above embodiment, from the first gas discharge means 8 can be discarged an inert gas, for example, argon or the like as a activation-assisting gas and from the second gas discharge means 9 can be discharged TEOS and oxygen or the like as a reaction gas.

## Claims

1. A film forming apparatus comprising:
first gas discharge means (8) for discharging a first reaction gas into a plasma forming part (1);
gas activating means for activating said first reaction gas;
second gas discharge means (9) for discharging a second reaction gas on a substrate in a film forming part (7); and
said second gas discharge means (9) being provided with gas discharge pipes (22a and 22b, 22c and 22d, 22e and 22f, or 22g and 22h) in walls of which a plurality of gas discharge holes are formed, whereby said second reaction gas is discharged from the gas discharge holes to contact said activated first reaction gas and is activated so that a film is formed on said substrate through reaction of said first reaction gas and second reaction gas.

2. The film forming apparatus according to claim 1, wherein said gas discharge pipes (22a and 22b, 22c and 22d, 22e and 22f, or 22g and 22h) are disposed above said substrate and are formed in an annular shape on a plane parallel to the surface of said substrate.

3. The film forming apparatus according to claim 2, wherein said second gas discharge means (9) is provided with a first gas conduit (21a) for communicating with the gas discharge pipes (22a and 22b, or 22c and 22d) so as to guide said second reaction gas thereto.

4. The film forming apparatus according to claim 2, wherein said second gas discharge means (9) is provided with a first gas coduit (21b) for guiding said second reaction gas, and a plurality of second gas conduits (23a, 23b) branching from said first gas coduit (21b) and communicating with said gas discharge pipes (22e and 22f, or 22g and 22h).

5. The film forming apparatus according to claim 1, further comprising:
an antenna (2) for applying an AC electric power thereby radiating an electric wave inside said plasma forming part (1); and
a solenoid coil (5, 6) for generating a magnetic field inside said plasma forming part (1), whereby said electric wave and said magnetic field cooperate to activate said first reaction gas introduced into said plasma forming part (1) and induce generation of a helicon mode plasma.

6. The film forming apparatus according to claim 5, wherein said AC electric power has a frequency of 13.56 MHz.

7. The film forming apparatus according to any of claims 1 through 6, wherein said first gas discharge means (8) is provided with a gas discharge opening disposed in the central part of said plasma forming part (1).

8. The film forming apparatus according to any of claims 1 through 6, wherein said first gas discharge means (8) is provided with a gas discharge pipe (8a) provided with a plurality of gas discharge holes formed in a wall of the gas discharge pipe (8a), and a relay plate (8b) fixed on a plate surface thereof to the end part of the gas discharge pipe (8a) so as to receive said first reaction gas discharged through said gas discharge holes on the plate surface and allow said first reaction gas thereon to flow past the edge part thereof in the direction of the film forming part (7).

9. A film forming apparatus comprising:
first gas discharge means (8) for discharging an activation-assisting gas into a plasma forming part (1);
gas activating means for activating said activation-assisting gas;
second gas discharge means (9) for discharging a reaction gas on a substrate in a film forming part (7); and
said second gas discharge means (9) being provided with gas discharge pipes (22a and 22b, 22c and 22d, 22e and 22f, or 22g and 22h) in walls of which a plurality of gas discharge holes are formed, whereby said reaction gas is discharged from the gas discharge holes to contact said activated activation-assisting gas and is activated so that a film is formed on said substrate through reaction of said reaction gas.

10. The film forming apparatus according to claim 9, wherein said gas discharge pipes (22a and 22b, 22c and 22d, 22e and 22f, or 22g and 22h) are disposed above said substrate and are formed in an annular shape on a plane parallel to the surface of said substrate.

11. The film forming apparatus according to claim 10, wherein said second gas discharge means (9) is provided with a first gas conduit (21a) for communicating with the gas discharge pipes (22a and 22b, or 22c and 22d) so as to guide said reaction gas thereto.

12. The film forming apparatus according to claim 10, wherein said second gas discharge means (9) is provided with a first gas coduit (21b) for guiding said reaction gas, and a plurality of second gas conduits (23a, 23b) branching from said first gas coduit (21b) and communicating with said gas discharge pipes (22e and 22f, or 22g and 22h).

13. The film forming apparatus according to claim 9, further comprising:
an antenna (2) for applying an AC electric power thereby radiating an electric wave inside said plasma forming part (1); and
a solenoid coil (5, 6) for generating a magnetic field inside said plasma forming part (1), whereby said electric wave and said magnetic field cooperate to activate said activation-assisting gas introduced into said plasma forming part (1) and induce generation of a helicon mode plasma.

14. The film forming apparatus according to claim 13, wherein said AC electric power has a frequency of 13.56 MHz.

15. The film forming apparatus according to any of claims 9 through 14, wherein said first gas discharge means (8) is provided with a gas discharge opening disposed in the central part of said plasma forming part (1).

16. The film forming apparatus according to any of claims 9 through 14, wherein said first gas discharge means (8) is provided with a gas discharge pipe (8a) provided with a plurality of gas discharge holes formed in a wall of the gas discharge pipe (8a), and a relay plate (8b) fixed on a plate surface thereof to the end part of the gas discharge pipe (8a) so as to receive said activation-assisting gas discharged through said gas discharge holes on the plate surface and allow said activation-assisting gas thereon to flow past the edge part thereof in the direction of the film forming part (7).
